Europäisches Patentamt

European Patent Office

Office européen des brevets

(11) Publication number : **0 563 500 B1**

(12) **EUROPEAN PATENT SPECIFICATION**

(45) Date of publication of patent specification :
25.10.95 Bulletin 95/43

(51) Int. Cl.⁶ : **H01J 37/073, H01J 3/02**

(21) Application number : **92810245.8**

(22) Date of filing : **01.04.92**

(54) **Source for intense coherent electron pulses.**

(43) Date of publication of application :
06.10.93 Bulletin 93/40

(45) Publication of the grant of the patent :
25.10.95 Bulletin 95/43

(84) Designated Contracting States :
**DE FR GB**

(56) References cited :
EP-A- 0 366 851
DE-A- 3 605 735
PHYSICAL REVIEW LETTERS, vol. 65, no. 10, 3
September 1990, New York US, pp. 1204-1206;
H.W. FINK et al.: "Holography with low-energy
electrons"
JOURNAL OF VACUUM SCIENCE AND
TECHNOLOGY: PART B. vol. 8, no. 6, 1990,
New York US, pp. 1323-1324; H.W. FINK et al.:
"Coherent point source electron beams"

(56) References cited :
JOURNAL OF ELECTRON MICROSCOPY, vol.
33, no. 2, 1984, TOKYO JP, pp. 101-115; A.
TONOMURA : "Applications of electron
holography using a field-emission electron mi-
croscope"

(73) Proprietor : **International Business Machines
Corporation
Old Orchard Road
Armonk, N.Y. 10504 (US)**

(72) Inventor : **Fink, Hans-Werner, Dr.
Mühleweg 15
CH-8136 Gattikon (CH)**
Inventor : **Schmid, Heinz
Bickelstrasse 10
CH-8942 Oberrieden (CH)**

(74) Representative : **Barth, Carl Otto et al
International Business Machines Corp.
Zurich Research Laboratory
Intellectual Property Department
Säumerstrasse 4
CH-8803 Rüschlikon (CH)**

## Description

This invention relates to a field-emission source for intense coherent electron pulses, particularly for use in electron microscopy and spectroscopy.

Pulsed particle beams are of interest wherever measurements with good time resolution are important. This is usually desired for the two conjugate mechanical observables, location and momentum. The first observable refers to the area of microscopy where time-dependent events in real space are to be resolved. The second observable refers to spectroscopy where time of flight measurements with pulsed beams are used to reveal momentum-, energy-, or mass spectra.

Field-emission sources generating free electrons are well known in the art. In most cases they take the form of pointed tips. Hence they are often referred to as point sources, and they are generally defined as a volume in real space of atomic dimensions, comparable to the wavelength of the electrons they emit. Yet conventional tips were just not pointed enough to really meet this definition: The employ of electron-optical lenses was necessary to form a small focus. Well known are also the various aberrations introduced by these lenses, and the coulomb repulsion problems occurring in the focus region.

With the introduction of the sharpest possible tip, i.e. the one ending in one single atom, the art of electron sources has attained a new dimension. Reference is made to the paper by H.-W. Fink et al., "Coherent point source electron beams", J. Vac. Sci. Technol. B 8 (6), Nov./Dec. 1990, pp. 1323/4. While certain applications might require the use of a single-atom tip, useful results can certainly be obtained in most cases with a tip ending in a hemisphere including about 100 atoms. Such a tip can still be called 'ultrasharp' when compared to conventional tips. The description below of an embodiment of the present invention will be based on a tip of this kind.

Ultrasharp tips have already been used as sources of coherent electron beams for the formation of holograms of objects arranged close to those sources. An example for a paper on the subject was published by H.-W. Fink et al., "Holography with Low-Energy Electrons", Phys. Rev. Lett. 65, No. 10, Sept. 1990, pp. 1204-1206. The projection microscope described in this reference comprises a point source for electrons, a perforated anode holding the object to be investigated, and a two-dimensional electron detector.

As has been explained in two other papers, namely by H.-W. Fink, "L'holographie électronique sans lentilles", La Recherche, Vol. 22, No. 234, Juillet/Août 1991, pp. 964-966, and by H.-W. Fink et al., "Atomic Resolution in Lensless Low-Energy Electron Holography", Phys. Rev. Lett. 67, No. 12, Sept. 1991, pp 1543-1546, these microscopes work without electromagnetic lenses, thus avoiding all of the disadvantages otherwise occurring.

While it is, thus, possible to obtain holographic images of objects with a theoretical resolution down to the atomic level, there are still at least two severe disadvantages inherent in the state of the art electron sources: One disadvantage has to do with the extreme sensitivity of the electron source/object arrangement with respect to vibrations. This leads to blurred images because the coherence of the electron source is lost in that the vibrations tend to simulate a more extended source. The other disadvantage is that only still objects can be investigated while it would be desirable to obtain information on moving objects or on objects that undergo changes during observation.

It is, therefore, one object of the present invention to overcome these disadvantages.

This object is achieved in accordance with the invention by a source for intense coherent electron pulses of an energy below 1 keV, which comprises an ultrasharp electron-emitting tip and an anode, both arranged in mutual alignment inside a vacuum envelope, wherein the source comprises means to apply a pulsed potential with an amplitude in the range between 100 V and 500 V and with a variable pulse rate between said tip and said anode, with the tip being negative with respect to said anode, said tip having a sharpness such that the electric field at the surface thereof exceeds $10^7$ V/cm at said pulsed potential.

The dependent claims describe particular embodiments of the invention.

Details of preferred embodiments of the invention will hereafter be described by way of example, with reference to the drawings in which:

**Fig. 1** shows a the general setup of a first embodiment of the electron pulse source of the invention;
**Fig. 2** is a second embodiment of the invention:
**Fig. 3** serves to explain the geometry of the electron pulse source;
**Fig. 4** depicts a further embodiment of the invention.

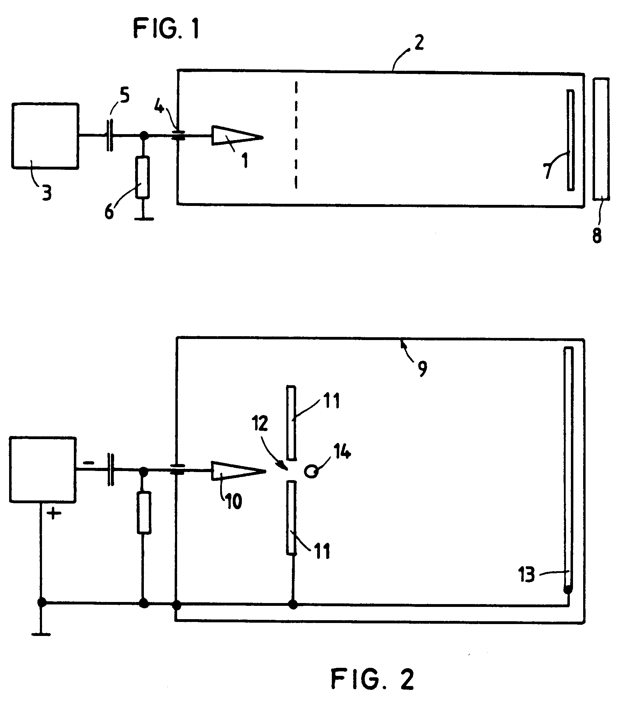

Fig. 1 shows a the general setup of the electron pulse source in accordance with the invention. An electron point source 1 is arranged inside a vacuum envelope 2, with its longitudinal axis aligned with the axis of the envelope 2. The point source may be of the kind described in H.-W. Fink, "Mono-atomic tips for scanning funneling microscopy", IBM J. Res. Dev., Vol. 30, No. 5, September 1986, pp. 460-465, but, as mentioned before, tips having more than a single atom at their apex may also be used.

Tip 1 is connected to a pulse generator 3 by means of a vacuum feedthrough 4 and via a capacitor 5. A resistor 6 having a resistance on the order of 50 $\Omega$ connects tip 1 to ground. Pulse generator 3 is adapted to supply a pulsed voltage of between -100 V and -500 V to tip 1, with a variable pulse rate as will be explained below.

Also arranged inside vacuum envelope 2 is an electron detector 7. Electron detectors are well known, and those skilled in the art will appreciate that several types of electron detectors are suitable for application in connection with the present invention. Reference is made to the following publications: J.L. Wiza, "Microchannel Plate Detectors", Nuclear Instr. & Methods, Vol. 162, 1979, pp. 587-601, and E.A. Kurz, "Channel Electron Multipliers", Reprint from American Laboratory, March 1979.

For example, if a channelplate detector is used, its disposition should be such that the electrons emitted from tip 1 may hit its surface essentially vertically. If a channeltron type of detector is used, its entrance cone should preferably be aligned with the axis of tip 1. Electron detector 7 may be connected to a conventional display and/or recording unit 8.

With the electron detector 7 having a positive potential with respect to tip 1, free electrons will be emitted from the tip by field emission, provided the electric field at the surface of tip 1 exceeds the value of about $10^7$ V/cm, enabling the electrons to "tunnel out" of the potential well and reach the positive electron detector 7. This relatively elevated field strength is easily reached with a very sharply pointed tip 1, in particular, if a tip with only a single atom at its apex is used.

The important parameters in characterizing a useful time-resolved setup are the number of electrons which cause the signal at some detector level, and the pulse duration of the electron beam.

In conventional electron microscopes with a resolution of only a few nanometers, about $10^8$ electrons are required for the generation of a high-contrast image at a two-dimensional electron detector, and within a time frame of a fraction of a second. Repetition times shorter than the usual fraction of a second would result in a significant loss of spatial resolution. And, of course, these electrons have a very high energy since conventional electron microscopes operate with acceleration voltages on the order of tens of kilovolts.

In contrast, the free electrons emitted from tip 1 of the electron source in accordance with the present invention have energies only in the range from 100 eV to 500 eV. As will be obvious to those skilled in the electron microscope art, low-energy electron beams lend themselves to the investigation, for example, of biological matter that would immediately be destroyed if impacted by the usual high-energy electron beams used in conventional electron microscopes.

In accordance with the invention, the potential across tip 1 and the anode is pulsed at high frequency. Assuming a typical pulse duration of 200 ns and a pulse duty factor of 1, there will be $2,5 \times 10^6$ pulses per second, and each pulse will accommodate

$$n = \frac{5 \times 10^{14}}{2,5 \times 10^6} = 2 \times 10^8 \text{electrons.}$$

Thus, the electron source in accordance with the invention provides for roughly the same number of electrons as the conventional field electron microscope, but the electrons provided have energies smaller by a factor of 100.

Referring now to Fig. 2, one possible application of the electron source of the present invention is the imaging, with atomic resolution, of objects placed in the trajectory of the electron beam. In a vacuum envelope 9, across a sharp field-emission tip 10 and an anode 11, which may, for example, be a metal sheet, there is applied a pulsed potential on the order of 100 V. The pulse frequency may be assumed as being about 5 MHz, thus providing pulses of 100 ns duration with a brightness of $10^8$ electrons each. A spherical wave of coherent radiation is, therefore, emitted from tip 10 and passes through an opening 12 in anode 11. The spherical wave spreads towards a screen 13 as far as it is not restricted by the edge of opening 12. Screen 13 is arranged opposite tip 10 and oriented orthogonally to the axis of the electron beam, at a distance large with respect to the tip 10/anode 12 distance.

Placing an object 14 in front of opening 12 within the electron beam will cause the spherical wave of electrons to become diffracted locally in such a way that the wave front arriving at screen 13 will generate an interference pattern thereon in the form of concentric rings the mutual spacing of which is a function of the phase difference between the original and diffracted waves.

Generally, two cases must be distinguished:

(1) The object is smaller than the diameter of the electron beam at the location of the object (Gabor Hologram). The interference pattern (hologram) on screen 13 will be generated by superposition of the undisturbed part of the electron beam (which usually is called the reference beam) with that part of the beam which was diffracted by the object.

(2) The object is so big that it completely blinds out the electron beam (Transmission Hologram). Obviously, in this case the object must at least be partially transparent to the electron beam. The interference pattern is generated by the electrons passing the object undisturbed and by those that interact with the atoms (or molecules) of the object while passing.

The reconstruction of a hologram is known in the art. Briefly, the hologram must be "illuminated" with a spherical wave analogous to the radiation that was used in its generation. Depending on which side of the hologram - with respect to the viewer - is illuminated, will the viewer see the real or the conjugate image.

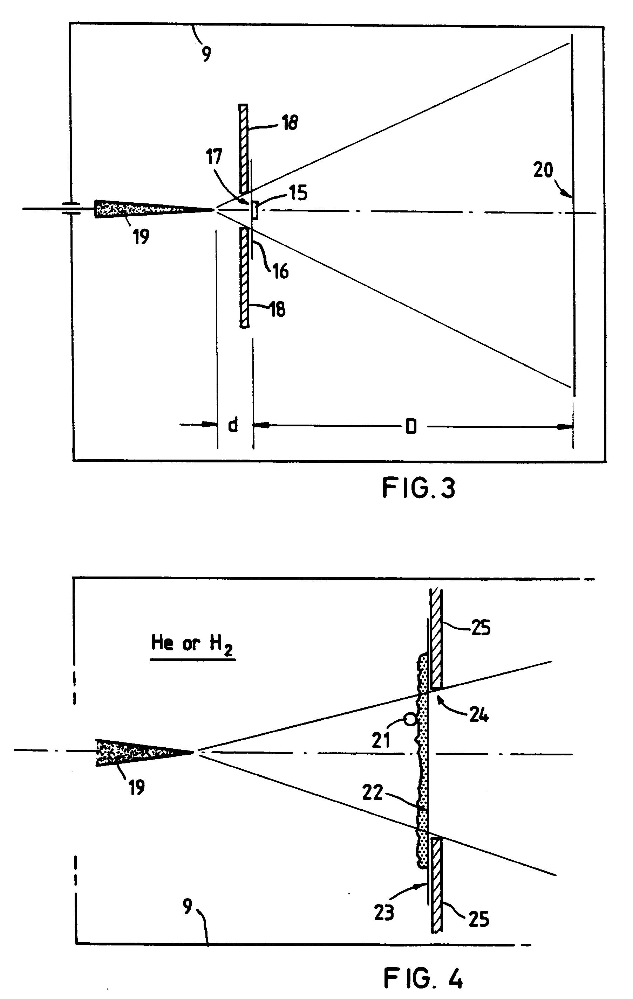

In the arrangement of Fig. 3 the object 15 to be inspected is supported on a thin film 16 (transparent to electrons) which is placed across the opening 17 in the anode 18. The distance d between tip 19 and anode 18 is chosen to be microscopic, say d = 10 nm, while the distance D between anode 18 and screen 20 is chosen to be macroscopic, say 10 cm. The magnification M provided by this arrangement is simply geometric: $M = D/d = 10^6$.

While in the arrangements shown in the preceding figures direct use was made of the pulsed electron beam emitted by the tip, Fig. 4 shows an embodiment where the usual vacuum is replaced by a gas atmosphere, such as helium or hydrogen. Accordingly, the pulsed electron beam will interact with the gas molecules, and there will be ionized He or $H_2$ (protons), as the case may be. Such an arrangement will, for example, permit the observation, say in 100 ns intervals, of the movement of charges 21 as they jump across an object 22 which is supported on a thin membrane 23 covering an opening 24 in anode 25.

Likewise, it will be possible to observe, down to an atomic level, certain chemical reactions as they take place, provided there are enough atoms/molecules involved in the reaction for an interference pattern to be generated.

## Claims

1. Source for intense coherent electron pulses of an energy below 1 keV, comprising an ultrasharp electron-emitting tip (1, 10, 19) and an anode (7, 11, 18, 25), both arranged in mutual alignment inside a vacuum envelope (2, 9), *characterized* in that the source comprises means (3) to apply a pulsed potential with an amplitude in the range between 100 V and 500 V and with a variable pulse rate between said tip (1, 10, 19) and said anode (7, 11, 18, 25), with the tip (1, 10, 19) being negative with respect to said anode (7, 11, 18, 25) and said tip (1) having a sharpness such that the electric field at the surface thereof exceeds $10^7$ V/cm at said pulsed potential.

2. Source for intense coherent electron pulses in accordance with claim 1, *characterized* in that said anode is an electron detector (7) connected to supply image data to a recording unit arranged outside of said vacuum envelope (2).

3. Source for intense coherent electron pulses in accordance with claim 1, *characterized* in that during use of the source said pulsed potential has a typical pulse duration of 200 ns and a duty factor of 1, whereby said tip (1, 10, 19) emits about $2,5 \times 10^6$ pulses per second, each pulse accommodating about $2 \times 10^8$ electrons.

4. Source for intense coherent electron pulses in accordance with claim 1, *characterized* in that said anode is designed as a metal sheet (11, 18) having an opening (12, 17) aligned with the axis of said tip (10, 19), that a screen (13, 20) is arranged opposite said tip (10, 19) and oriented orthogonally with respect to the axis of the electron beam passing said opening (12, 17), and that the distance between said opening (12, 17) and said screen (13, 20) is large as compared to the distance between said tip (10, 19) and said anode (11, 18).

5. Source for intense coherent electron pulses in accordance with claim 4, *characterized* in that an object (14) is arranged downstream in front of the opening (12) in said anode (11) within the electron beam, such that the spherical wave of electrons arriving at said screen (13) generates an interference pattern thereon, namely a Gabor hologram in case said object (14) is smaller than the diameter of said opening (12), and a transmission hologram in the case said object (14) is bigger than the diameter of said opening (12) and at least partially transparent to the electron beam.

6. Source for intense coherent electron pulses in accordance with claim 4, *characterized* in that an object (15) is arranged on a thin film (16) transparent to electrons and placed across said opening (17) in said anode (18), that the distance between said tip (19) and said anode (18) is on the order of 10 nm, and that the distance between said anode (18) and said screen (20) is on the order of 10 cm, providing a magnification of about six orders of magnitude.

7. Source for intense coherent electron pulses in accordance with any one of claims 1 through 6, **characterized** in that said vacuum envelope (2, 9) contains an atmosphere of gas selected from the group comprising hydrogen and helium, the pulsed electrons emitted from said tip (1, 10, 19) thus interacting with the gas molecules causing at least part thereof to become ionized.

8. Source for intense coherent electron pulses in accordance with claims 1 and 7, **characterized** in that an object (22) is arranged on a thin membrane (23) covering said opening (24) in said anode (25), said pulsed ionized gas atmosphere permitting the observation of charges (23) as they move across said object (22).

## Patentansprüche

1. Quelle für intensive, kohärente, gepulste Elektronen mit einer Energie unter 1 keV, eine ultrafeine, Elektronen aussendende Spitze (1, 10, 19) und eine Anode (7, 11, 18, 25) umfassend, die beide aufeinander ausgerichtet in einem Vakuumkolben (2, 9) angeordnet sind, dadurch gekennzeichnet, daß die Quelle Mittel (3) zum Anlegen eines gepulsten Potentials mit einer Amplitude im Bereich zwischen 100 V und 500 V und mit einer variablen Impulsrate zwischen der genannten Spitze (1, 10, 19) und der genannten Anode (7, 11, 18, 25) umfaßt, wobei die Spitze (1, 10, 19) bezogen auf die genannte Anode (7, 11, 18, 25) negativ ist, und die genannte Spitze (1) so fein ist, daß das elektrische Feld an ihrer Oberfläche bei dem genannten gepulsten Potential $10^7$ V/cm überschreitet.

2. Quelle für intensive, kohärente, gepulste Elektronen gemäß Anspruch 1, dadurch gekennzeichnet, daß die genannte Anode ein Elektronendetektor (7) ist, der so angeschlossen ist, daß er Bilddaten an eine Aufzeichnungseinheit liefert, die außerhalb des genannten Vakuumkolbens (2) angeordnet ist.

3. Quelle für intensive, kohärente, gepulste Elektronen gemäß Anspruch 1, dadurch gekennzeichnet, daß beim Einsatz der Quelle das genannte gepulste Potential eine typische Impulsdauer von 200 ns und ein Tastverhältnis von 1 hat, wodurch die genannte Spitze (1, 10, 19) etwa $2,5 \times 10^6$ Impulse pro Sekunde aussendet, wobei jeder Impuls etwa $2 \times 10^8$ Elektronen hat

4. Quelle für intensive, kohärente, gepulste Elektronen gemäß Anspruch 1, dadurch gekennzeichnet, daß die Anode als Metallblech (11, 18) ausgeführt ist, mit einer Öffnung (12, 17), die mit der Achse der genannten Spitze (10, 19) ausgerichtet ist, daß ein Schirm (13, 20) gegenüber der genannten Spitze (10, 19) angeordnet und, bezogen auf die Achse des die genannte Öffnung (12, 17) passierenden Elektronenstrahls, orthogonal ausgerichtet ist, und daß der Abstand zwischen der genannten Öffnung (12, 17) und dem genannten Schirm (13, 20), verglichen mit dem Abstand zwischen der genannten Spitze (10, 19) und der genannten Anode (11, 18), groß ist.

5. Quelle für intensive, kohärente, gepulste Elektronen gemäß Anspruch 4, dadurch gekennzeichnet, daß ein Objekt (14) dahinter vor der Öffnung (12) in der genannten Anode (11) in dem Elektronenstrahl angeordnet ist, so daß die Kugelwelle der Elektronen, die an dem genannten Schirm (13) eintrifft, darauf ein Interferenzmuster erzeugt, und zwar ein Gabor-Hologramm, wenn das genannte Objekt (14) kleiner ist, als der Durchmesser der genannten Öffnung (12), und ein Transmissions-Hologramm, wenn das genannte Objekt (14) größer als der Durchmesser der genannten Öffnung (12) und für den Elektronenstrahl zumindest teilweise transparent ist.

6. Quelle für intensive, kohärente, gepulste Elektronen gemäß Anspruch 4, dadurch gekennzeichnet, daß ein Objekt (15) auf einem dünnen Film (16), der für die Elektronen transparent ist, angeordnet ist, und dieser Film über die genannte Öffnung (17) in der genannten Anode (18) gelegt wird, daß der Abstand zwischen der genannten Spitze (19) und der genannten Anode (18) etwa 10 nm beträgt, und der Abstand zwischen der genannten Anode (18) und dem genannten Schirm (20) etwa 10 cm beträgt, woraus sich eine etwa sechsfache Vergrößerung ergibt.

7. Quelle für intensive, kohärente, gepulste Elektronen gemäß jedem der Ansprüche 1 bis 6, dadurch gekennzeichnet, daß der genannte Vakuumkolben (2, 9) eine Gasatmosphäre enthält, die aus der Gruppe ausgewählt wird, zu der Wasserstoff und Helium gehören, wodurch die von der genannten Spitze (1, 10, 19) ausgesendeten gepulsten Elektronen mit den Gasmolekülen in Wechselwirkung treten und bewirken, daß zumindest ein Teil davon ionisiert wird.

8. Quelle für intensive, kohärente, gepulste Elektronen gemäß Anspruch 1 und Anspruch 7, dadurch gekennzeichnet, daß ein Objekt (22) auf einer dünnen Membrane (23) angeordnet wird, welche die genannte Öffnung (24) in der genannten Anode (25) abdeckt, wobei die genannte gepulste, ionisierte Gasatmosphäre die Beobachtung von Ladungen (23) ermöglicht, die sich über das genannte Objekt (22) bewegen.

**Revendications**

1. Source pour impulsions d'électrons cohérentes intenses d'une énergie inférieure à 1 keV, comprenant une pointe émettrice d'électrons ultra-pointue (1, 10, 19) et une anode (7, 11, 18, 25) disposées toutes deux en alignement mutuel dans une enveloppe à vide (2, 9), *caractérisée en ce que* ladite source comprend un élément (3) pour appliquer un potentiel pulsé caractérisé par une amplitude comprise entre 100 V et 500 V et par une fréquence de récurrence variable entre ladite pointe (1, 10, 19) et ladite anode (7, 11, 18, 25), ladite pointe (1, 10, 19) étant négative par rapport à ladite anode (7, 11, 18, 25) et étant caractérisée par une finesse telle que le champ électrique à la surface de celle-ci dépasse $10^7$ V/cm au dit potentiel pulsé.

2. Source pour impulsions d'électrons cohérentes intenses selon la revendication 1, *caractérisée en ce que* ladite anode est un détecteur d'électrons (7) est connecté pour transmettre des données vidéo à une unité d'enregistrement disposée à l'extérieur de ladite enveloppe à vide (2).

3. Source pour impulsions d'électrons cohérentes intenses selon la revendication 1, *caractérisée en ce que*, au cours de l'utilisation de ladite source, ledit potentiel pulsé a une durée d'impulsion caractéristique de 200 ns et un facteur de forme de 1, ladite pointe (1, 10, 19) émettant ainsi environ $2,5 \times 10^6$ impulsions par seconde, chaque impulsion accommodant environ $2 \times 10^8$ électrons.

4. Source pour impulsions d'électrons cohérentes intenses selon la revendication 1, *caractérisée en ce que* ladite anode est conçue sous la forme d'une feuille métallique (11, 18) munie d'une ouverture (12, 17) alignée avec l'axe de ladite pointe (10, 19), en ce qu'un écran (13, 20) est disposé en face de ladite pointe (10, 19) et orienté perpendiculairement à l'axe du faisceau d'électrons traversant ladite ouverture (12, 17), et ne ce que la distance entre ladite ouverture (12, 17) et ledit écran (13, 20) est grande comparée à la distance entre ladite pointe (10, 19) et ladite anode (11, 18).

5. Source pour impulsions d'électrons cohérentes intenses selon la revendication 4, *caractérisée en ce que* un objet (14) est placé en aval devant l'ouverture (12) d ans ladite anode (11) au sein du faisceau d'électrons, de façon à ce que l'onde sphérique d'électrons arrivant sur ledit écran (13) génère une figure d'interférence sur celui-ci, à savoir un hologramme de Gabor, dans le cas où ledit objet (14) est inférieur en taille au diamètre de ladite ouverture (12), et un hologramme de transmission dans le cas où ledit objet (14) est supérieur en taille au diamètre de ladite ouverture (12) et au moins partiellement transparent au faisceau d'électrons.

6. Source pour impulsions d'électrons cohérentes intenses selon la revendication 4, *caractérisée en ce que* un objet (15) est disposé sur une couche mince (16) transparente aux électrons placée au travers de ladite ouverture (17) dans ladite anode (18), en ce que la distance entre ladite pointe (19) et ladite anode (10) est de l'ordre de 10 nm, et en ce que la distance entre ladite anode (18) et ledit écran (20) est de l'ordre de 10 cm, assurant un grossissement d'environ six ordres de grandeur.

7. Source pour impulsions d'électrons cohérentes intenses selon les revendications 1 à 6, *caractérisée en ce que* ladite enveloppe à vide (2, 9) contient une atmosphère d'un gaz sélectionné dans le groupe comprenant l'hydrogène et l'hélium, les électrons pulsés émis par ladite pointe (1, 10, 19) interagissant ainsi avec les molécules de gaz pour induire l'ionisation d'au moins une partie d'entre elles.

8. Source pour impulsions d'électrons cohérentes intenses selon les revendications 1 et 7, *caractérisée en ce que* un objet (22) est disposé sur une fine membrane (23) couvrant ladite ouverture (24) dans ladite anode (25), ladite atmosphère de gaz ionisé pulsé permettant l'observation des charges (23) qui se déplacent à travers ledit objet (22).

FIG. 1

FIG. 2

FIG.3

FIG. 4